Europäisches Patentamt

European Patent Office

Office européen des brevets

(19)

(11) Publication number: **0 019 241**
**B1**

## (12) EUROPEAN PATENT SPECIFICATION

(45) Date of publication of patent specification: **30.11.83**

(51) Int. Cl.³: **G 11 C 8/00, G 11 C 11/40**

(21) Application number: **80102590.9**

(22) Date of filing: **09.05.80**

(54) **Word line selection in a semi-conductor memory device.**

(30) Priority: **10.05.79 JP 57250/79**

(43) Date of publication of application:
**26.11.80 Bulletin 80/24**

(45) Publication of the grant of the patent:
**30.11.83 Bulletin 83/48**

(84) Designated Contracting States:
**DE FR GB NL**

(56) References cited:
**EP - A - 0 006 958**
**EP - A - 0 011 448**
**EP - A - 0 011 835**
**DE - A - 2 733 514**
**GB - A - 1 534 198**
**US - A - 3 778 784**
**US - A - 3 786 437**
**US - A - 3 810 124**
**US - A - 3 946 369**
**US - A - 3 962 686**
**US - A - 4 110 842**

(73) Proprietor: **NEC CORPORATION**
**33-1, Shiba 5-chome, Minato-ku**
**Tokyo 108 (JP)**

(72) Inventor: **Akatsuka, Yasuo**
**c/o Nippon Electric Co., Ltd. 33-1, Shiba Gochome**
**Minato-ku,Tokyo (JP)**

(74) Representative: **Glawe, Delfs, Moll & Partner**
**Patentanwälte**
**Postfach 26 01 62 Liebherrstrasse 20**
**D-8000 München 26 (DE)**

(56) References cited:
**IEEE JOURNAL OF SOLID-STATE CIRCUITS, vol. SC-13, nr. 5, October 1978 NEW YORK (US) K. SHIMOTORI et al.: "A 50 ns 4K STATIC DSA MOS RAM", pages 639-646**
**IEEE JOURNAL OF SOLID-STATE CIRCUITS, vol. SC-13, nr. 3, June 1978 NEW YORK (US) E. ARAI et al.: "A 64-kbit Dynamic MOS RAM", pages 333-338**

Courier Press, Leamington Spa, England.

Word line selection in a semi-conductor memory device

The invention relates to a memory device comprising a plurality of word lines, a plurality of memory cells, word selection means, a plurality of first word drive means each coupled to a first portion of an associated one of said word lines for driving the associated one of said word lines to a selection level when selected, a plurality of second word drive means each coupled to an associated one of said word lines at a second portion thereof different from said first portion for operatively driving the associated one of said word lines together with the associated first word drive means.

Memory devices of this kind are generally made as semiconductor memory devices (IC memory) on a semiconductor substrate. With increasing degree of integration and operation speed of IC memory devices polycrystalline silicon layers are widely employed for forming word lines because they are suitable for small-sized, fine patterning and enable self-aligning between semiconductor regions and silicon gates. However, the sheet resistance of the polycrystalline silicon is larger than that of conventional metal material. Accordingly, between the both ends of word lines formed of the polycrystalline silicon there is a relatively large impedance and hence a large delay time, corresponding to the time constant determined by the impedance and capacitance of the word line is produced between the both ends of the word line. This delay in the word line occupies a large part of a total delay in the whole memory circuit and occupies 20~30% of the access time.

A memory device of the aforementioned kind has been known from GB—A 1 534 198, and in connection with the aforementioned problem of improving the access time especially in the case of word lines formed of a polycrystalline silicon layer, this prior art discloses to locate the word selection means substantially in the middle of the word lines or to use a plurality of word selection means. In the latter case, however, this prior art document does not disclose the manner of controlling such a plurality of word selection means.

A memory device of the aforementioned kind is also disclosed in EP—A—0 011 448, which under article 54 (3) EPC constitutes a prior art document. In this memory device each word line has a drive circuit at one end and an amplifier located at an intermediate point along the word line, with the first portion of the word line being driven by the signals directed from the drive circuit acting as word selection means, whereas the remaining part of the word line is driven by the signals amplified by the amplifier.

From US—A—3 810 124 there has been known a memory device in which the activation of a drive circuit at one end of a word line is detected at the other end of the word line and the detected signal is used to control a pull down switch. This known arrangement has the purpose of avoiding noise in non-selected word lines by forcing the non-selected word lines on a non-selected level. This prior art is not concerned with the use of more than one drive circuit or word selection means for each word line of the purpose of reducing the access time.

It is the object of the invention to provide a memory device of the aforementioned kind which has a still further improved high operation speed and which can be produced as an IC memory with high integration and hence having a large memory capacity.

According to the invention a memory device of the aforementioned kind is characterized in that the memory device further comprises a plurality of detection means each coupled to an associated one of said word lines at a portion thereof different from said first portion for detecting an initiation of a change towards said selection level in the associated one of said word lines and each of said second word drive means is controlled by an output signal of the associated one of said detection means, a section between said first and second portions of selected ones of said word lines being driven towards the selection level by both the associated first drive means and the associated second drive means.

In the above memory device, the driving ability of the second word drive circuits is favorably set larger than the first word drive circuits.

The detection circuit may be made of an inverter circuit having an input coupled to another portion of the word line and the second word drive circuit may be made of an insulated-gate field-effect transistor (IGFET) coupled between a power supply and another portion of the word line, a gate of which is supplied with the detection signal.

According to the present invention, the word line can be provided with the voltage for introducing the selection level at a plurality of different portions (i.e. "a portion" and "another portion") thereof and hence as a whole the selected word line can be quickly turned to the selection level without influence of its time constant. As a result, high speed operation can be achieved.

Furthermore, the driving ability of the first word drive circuits may be small and hence IGFETs forming them can be made small size. As a whole, the memory device according to the present invention can be with high integration.

Brief description of the drawings:
Fig. 1 is a block diagram showing a conventional memory device;
Fig. 2 is a circuit diagram showing a memory cell;

Fig. 3 is a circuit diagram showing a word line of Fig. 1;

Fig. 4 is a wave form diagram showing changes in level of the word line in Fig. 3;

Fig. 5 is a block diagram showing a memory device according to a first embodiment of the present invention;

Fig. 6 is a circuit diagram showing the characteristic part of a memory according to a second embodiment of the present invention;

Fig. 7 is a waveform diagram showing operation of the circuit in Fig. 6;

Fig. 8 is a circuit diagram showing a characteristic part of a memory device according to a third embodiment of the present invention;

Fig. 9 is a circuit diagram showing a characteristic part of a memory device according to a fourth embodiment of the present invention;

Fig. 10 is a waveform diagram showing an operation of the circuit in Fig. 9;

Fig. 11 is a circuit diagram showing a memory device according to a fifth embodiment of the present invention;

Fig. 12 is a circuit diagram showing a memory device according to a sixth embodiment;

Fig. 13 is a block diagram showing a major part of a memory device according to a seventh embodiment of the present invention; and

Fig. 14 is a waveform diagram showing an operation of the circuit of Fig. 13.

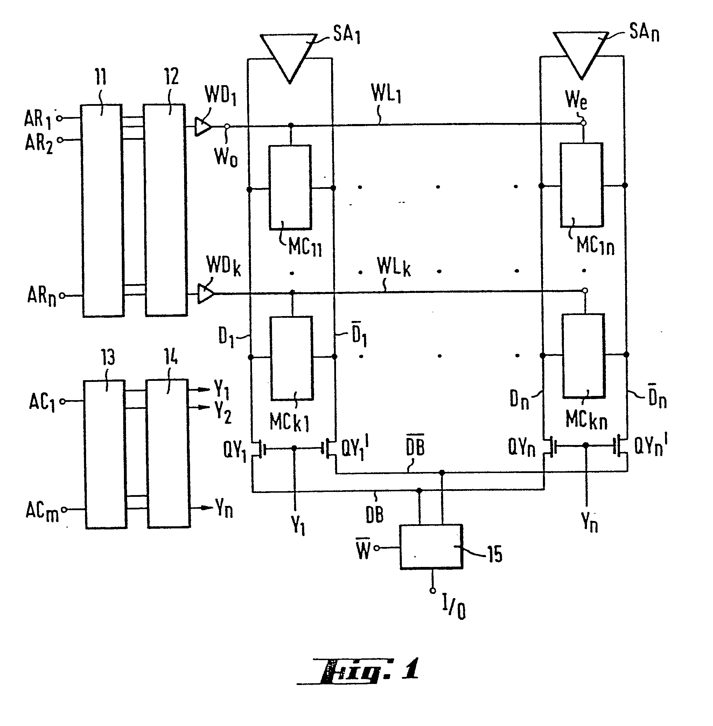

First, with reference to Figs. 1 to 4, a semiconductor memory device according to the prior art will be described.

A whole structure of the memory device is shown in Fig. 1. A row address inverter buffer 11 receives a plurality of row address signals $AR_1 \sim AR_n$ to produce their true and complementary address signals. A row decoder 12 receives the true and complementary address signals and makes one of its n pieces of outputs at a selection level. A plurality of word driver circuits $WD_1 \sim WD_k$ are respectively coupled between a plurality of word lines $WL_1 \sim WL_k$ and the outputs of the decoder 12. The word driver circuits $WD_1 \sim WD_k$ selectively drive one of the word line between the selection level and the non-selection level. A plurality pairs of digit lines $D_1, \overline{D_2} \ldots D_n, \overline{D_n}$ intersect the word lines $WL_1 \sim WL_k$. At the respective intersection of the word lines and the digit line pairs, a plurality of memory cells $MC_{11} \sim MC_{kn}$ and arranged. Digit data sense circuits $SA_1 \sim SA_n$ amplify data read on the digit line pairs. A column address inverter buffer 13 receives a plurality of column address input signals $AC_1 \sim AC_m$ and produces their true and complementary address signals. A column decoder 14 receives the address signals from the column address inverter buffer 13 and makes one of its selection outputs $Y_1 \sim Y_n$ at the selection level. True and complementary read data on the digit line pairs are transferred to a pair of bus lines DB and $\overline{DB}$ through a plurality pairs of transfer gate transis-

tors $QY_1, QY_1' \ldots QY_n, QY_n'$. An input/output circuit 15 coupled to the bus lines DB and $\overline{DB}$ is controlled by a write enable signal $\overline{W}$ between a read mode and a write mode and outputs readout data at an input output common terminal I/O or transfers write data applied to the terminal I/O to the bus lines DB and $\overline{DB}$.

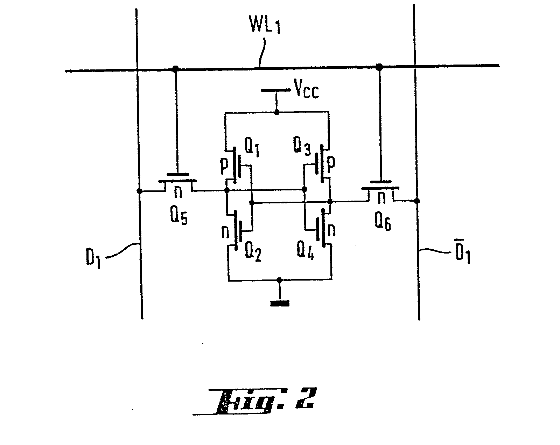

Fig. 2 shows a structure of the memory cells $(MC_{11} \sim MC_{kn})$ shown in Fig. 1.

The memory cells comprise P-channel IGFETs $Q_1$ and $Q_3$, and N-channel IGFETs $Q_2, Q_4, Q_5$ and $Q_6$. IGFETs $Q_1$ to $Q_4$ form a flip-flop circuit as a bi-stable circuit. IGFETs $Q_5$ and $Q_6$ have gates coupled to the word line (e.g. $WL_1$) and transfer a true and a complementary output signals of the flip-flop circuit to the pair of digit lines (e.g. $D_1$ and $\overline{D_1}$).

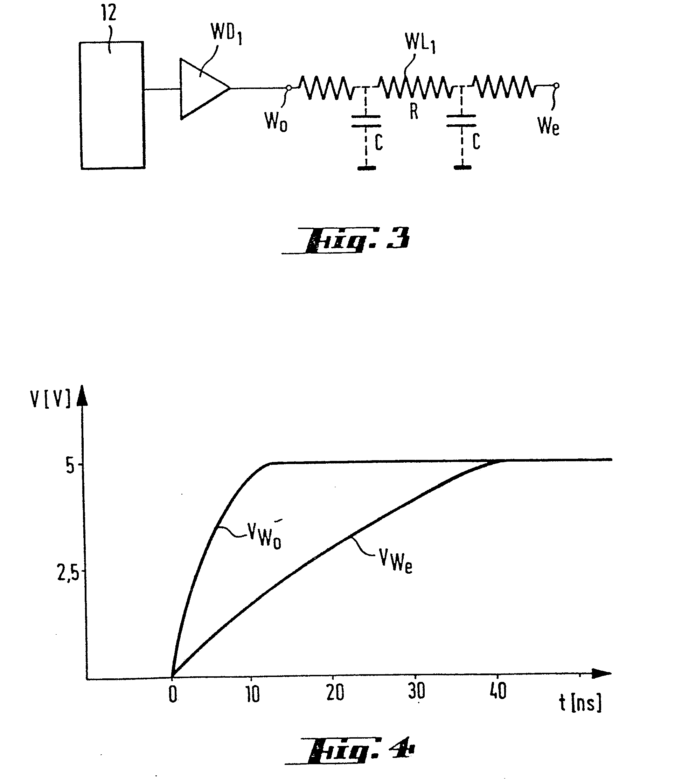

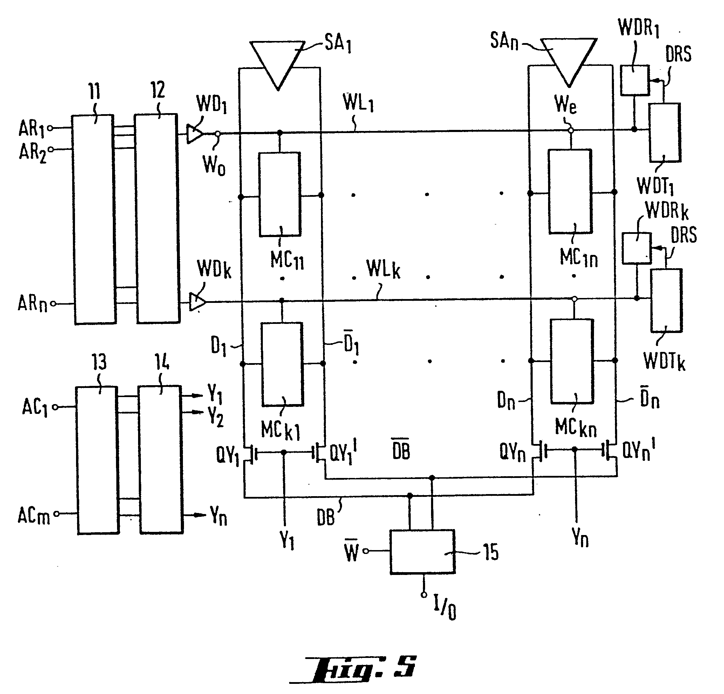

With reference to Figs. 3 and 4 a problem in the word line of the prior art memory device will be described.

In Fig. 3, the word line $WL_1$ is usually made of a polycrystalline silicon having a sheet resistance and has a relatively large resistance R in its longitudinal direction. Also large capacitance C including its stray capacitance and load capacitance is attached to the word line $WL_1$. Thus, the word line $WL_1$ inevitable has a large time constant (R×C) in its longitudinal direction, and hence access to the memory cell arranged near a remote end $W_e$ of is delayed with a large extent.

Waveforms of a near end $W_0$ to the word driver circuit $WD_1$ and the remote end $W_e$ are shown in Fig. 4. In this case, as a power voltage, 5V is employed. Waveform $V_{wo}$ shows a voltage change at the near end $W_0$ while waveform $V_{we}$ show a voltage change at the remote end $W_e$. As is clear from Fig. 4, rise of voltage ($V_{we}$) at the remote end $W_e$ is delayed from the rise of $V_{wo}$ bt about 30 nano sec, which occupies a large part in access time. As a result, high speed operation cannot be expected.

Now with reference to Fig. 5, a first embodiment of the present invention will be described.

In Fig. 5, word level detection circuits $WDT_1 \sim WDT_k$ are coupled to the respective word lines at their remote end. The word level detection circuits detect an initiation of a change from a non-selection level to a selection level in the respective word lines. If the initiation is detected, the word level detection circuit ($WDT_1$) produces a detection signal DRS and supplies it to an associated select word drive circuit $WDR_1$ or $WDR_k$ coupled to the remote end of the word line ($WL_1$, $WL_k$). The select word circuit $WDR_1$ or $WDR_k$ provides the associated word line with the selection level. Thus, the word line to be selected is forcibly made at the selection level without the time delay near the remote ends. The portion of the word lines to which the word level detection circuit and the select word drive circuit are connected is not limited to the remote end.

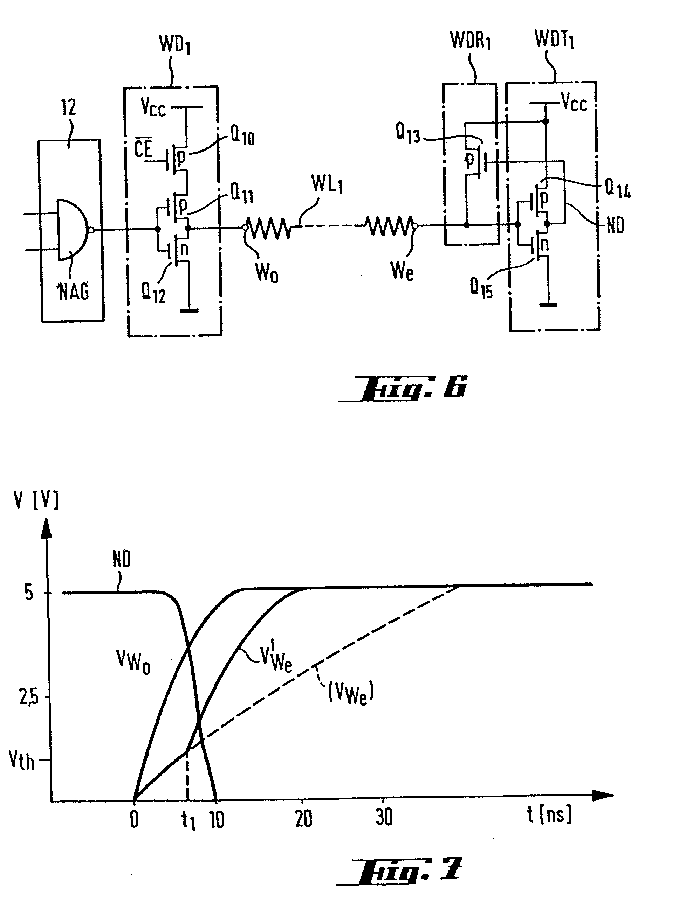

With reference to Figs. 6 and 7, a second embodiment of the present will be described in detail.

In Fig. 6, the word drive circuit $WD_1$ comprises P-channel IGFETs $Q_{10}$ and $Q_{11}$ and an N-channel $Q_{12}$. IGFETs $Q_{11}$ and $Q_{12}$ form an inverter circuit receiving a decode signal from a NAND gate NAG forming the decoder 12. IGFET $Q_{10}$ receives a chip enable signal $\overline{CE}$ at its gate and enables the inverter in response to the row level of $\overline{CE}$. An output of the word drive circuit $WD_1$ is applied to a portion of the word line $WL_1$ (in this case the near end $W_o$). The word level detection circuit $WDT_1$ is made of an inverter including P-channel IGFET $Q_{14}$ and an N-channel IGFET $Q_{15}$, whose gates are coupled to a portion of the word line which is different from the portion coupling to the word drive circuit. The select word drive circuit $WDR_1$ is made of a P-channel IGFET $Q_{13}$ coupled between the power voltage $V_{cc}$ and a portion of the word line (in this case the remote end $W_e$) at its drain and source and receiving an output ND of the circuit $WDT_1$ at its gate.

A selection operation of the circuits shown will be explained by referring to Fig. 7.

The waveform $V'_{we}$ shows a voltage change at the remote end $W_e$ of the word line $WL_1$. At time=0, the word drive circuit $WD_1$ starts to supply the end $W_o$ with the selection level i.e. $V_{cc}$. From this time point, the level $V'_{we}$ starts to rise in the similar curve as in Fig. 4. At this time point $t_1$ the level of $V'_{we}$ exceeds a logic threshold level $V_{th}$ of the inverter including IGFETs $Q_{14}$ and $Q_{15}$ so that the output signal ND starts to fall in level. At the same time, the IGFET $Q_{13}$ conducts. Therefore, the level $V'_{we}$ of the remote end rapidly rises towards the high level (selection level) of 5V.

Thus, the word line is quickly raised to the selection level. As is clear from the figure, the word line can be set at the selective level within about 20 nano sec as a whole and high speed operation is obtained. Here, the threshold level $V_{th}$ is optionally set by the ratio of gm between IGFETs $Q_{14}$ and $Q_{15}$.

Fig. 8 shows a third embodiment of the present invention. This embodiment includes a word level detection circuit $WDT_1'$ made of a P-channel IGFET $Q_{51}$ and an N-channel IGFET $Q_{52}$ and a selection word drive circuit $WDR_1$ made of an N-channel IGFET $Q_{53}$. In this embodiment, the level of a non-selected word line ($WL_1$) is at $V_{cc}$ level and the level of a selected word line is at ground potential. Thus the operations of the third embodiment are self-explanatory because they can be analogized by inverting the polarity of the second embodiment.

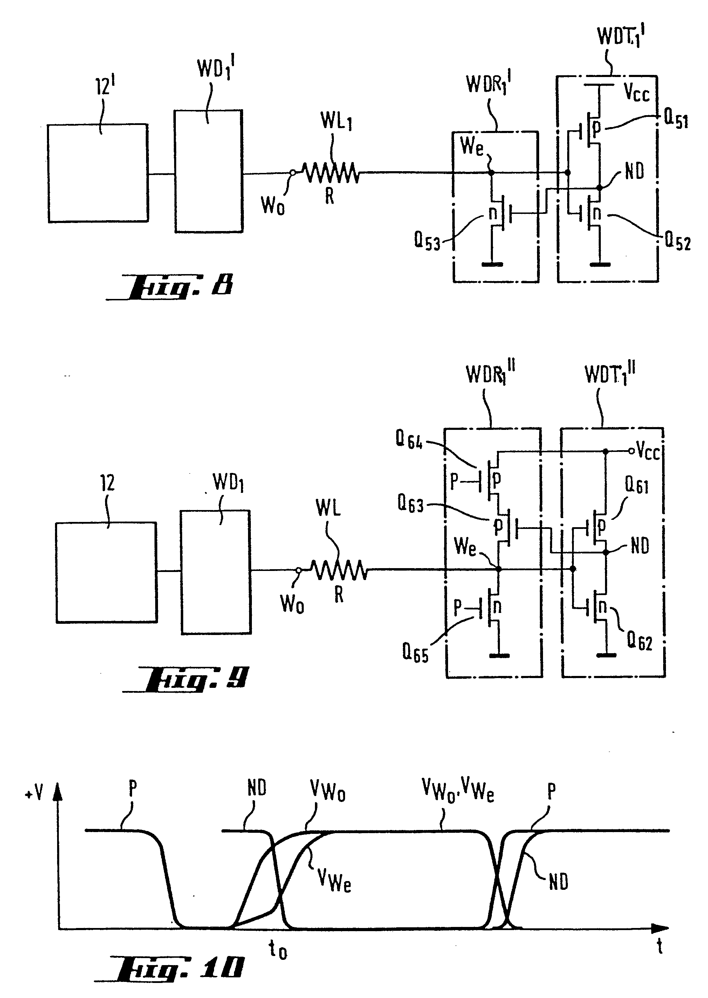

Fig. 9 shows a fourth embodiment of the present invention, in which a reset structure is added to the selection word drive circuit $WDT_1''$.

Fig. 10 is a timing chart showing the operations of the circuit of Fig. 9, in which waveforms $V_{wo}$, $V_{we}$ represent the level at the portions $W_o$ and $W_e$ respectively.

In Fig. 9, the word level detection circuit $WDT_1''$ includes a P-channel IGFET $Q_{61}$ and an N-channel IGFET $Q_{62}$ and has the same structure as the circuit $WDT_1$ in Fig. 6. The IGFETs $Q_{64}$ and $Q_{65}$ have their respective gates supplied with reset signals P so that the IGFET $Q_{64}$ is rendered conductive whereas the IGFET $Q_{65}$ is rendered nonconductive when the reset signal P is at a low level to introduce an active period. Thus, this embodiment operates similarly to the first embodiment during the active period. On the contrary, when the reset signals P is turned a high level to introduce a reset period, the IGFET $Q_{64}$ is rendered nonconductive whereas the IGFET $Q_{65}$ is rendered conductive so that the remote end We promptly is turned to a low level, i.e., so that the selected word line is brought into its reset condition. Simultaneously with this, the IGFET $Q_{61}$ is rendered conductive whereas the transistor $Q_{62}$ is rendered nonconductive so that the output signal takes a high level. Accordingly, the circuits $WDT_1''$ and $WDR_1''$ are brought into reset condition.

Fig. 11 shows a fifth embodiment of the present invention. In this embodiment, the word level detection circuit $WDT_1'''$ is similarly structured as in $WDT_1$ in Fig. 6. A select word drive circuit $WDR_1'''$ is composed of a P-channel IGFET $Q_{71}$ and an N-channel IGFET $Q_{72}$. A word enable timing signal WE which is produced within the memory device in response to the chip enable signal is applied to a drain of IGFET $Q_{71}$. IGFET $Q_{72}$ is used to reset the level of the word line in response to the precharge signal P.

The foregoing description is directed to the case, in which the circuits, $WDT_1$, $WDT_1'...$ and $WDR_1$, $WDR_1'...$ according to the present invention are disposed at the opposite position to that of the decoder circuit and the word drive circuit with respect to the word line with a view to reducing the signal delay especially in case the word line has a high wiring impedance. However, the effects of the present invention are not limited to the above cases.

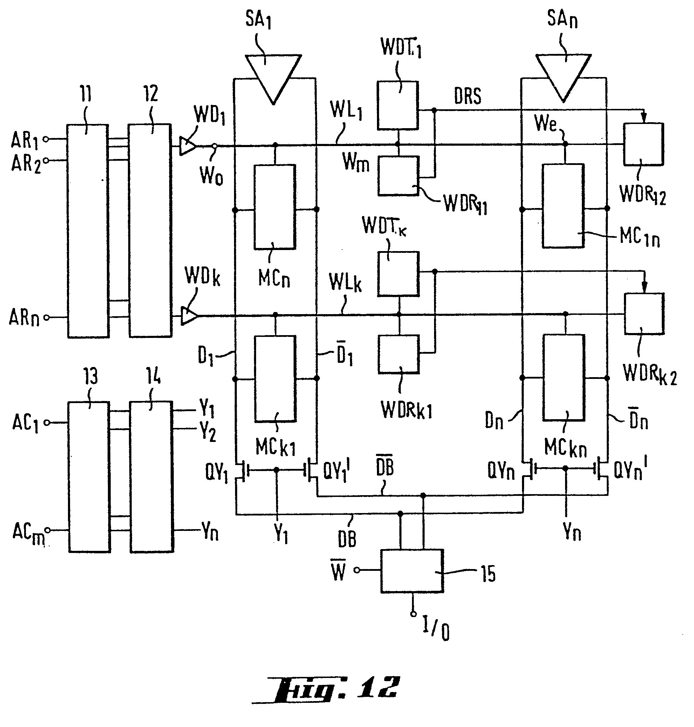

A sixth embodiment of the present invention will be described with reference to Fig. 12. In this embodiment, the word level detection circuit $WDT_1$ is disposed at a middle portion $W_m$ of the word line $WL_1$. With respect to one word line $WL_1$, two select word drive circuits $WDR_{11}$ and $WDR_{12}$ are disposed respectively at the middle portion $W_m$ and the remote end $W_e$ of the word line. The word level detection circuit $WDT_2$ and the select word drive circuits $WDR_{11}$ and $WDR_{12}$ may be constructed similarly in the preceding embodiments.

Another embodiment attaining the effects of the present invention will be described in the following.

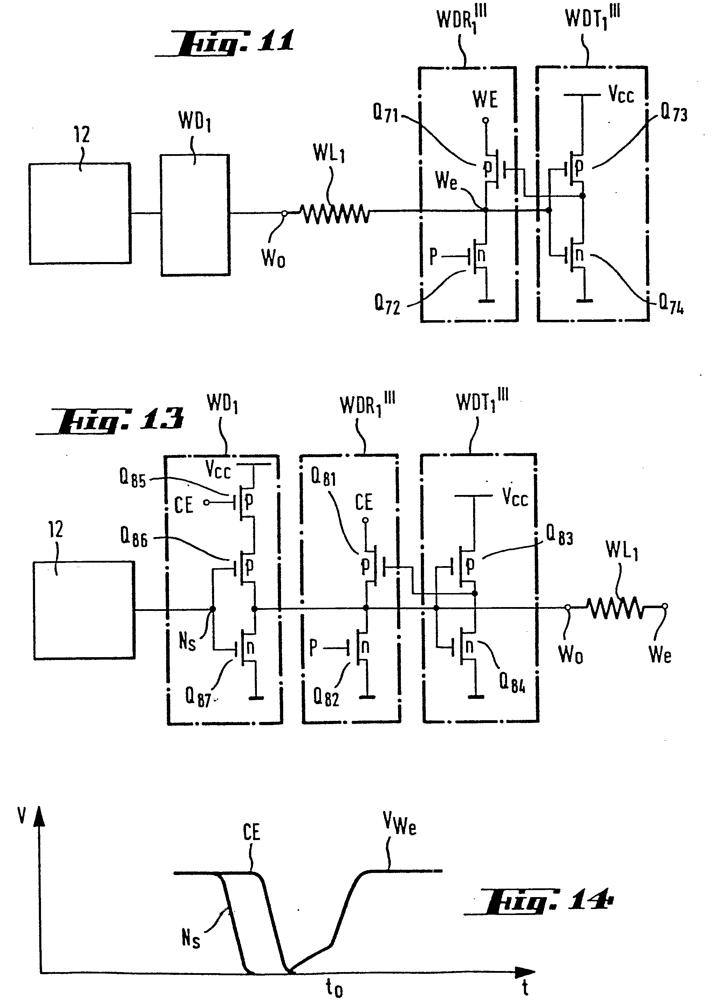

Fig. 13 is a circuit diagram showing a seventh embodiment of the present invention, and Fig. 14 is a timing chart of the same, in which a wave form $V_{we}$ shows the level at the

portion $W_e$ of the word line. In this embodiment, the word level detection circuit $WDT_1''''$ is disposed at the near end $W_0$ of the word line $WL_1$. The circuits $WDT_1''''$ and $WDR_1''''$ are substantially the same as the circuits $WDT_1'''$ and $WDR_1'''$ in Fig. 11 except that the chip enable signal CE is applied to a drain of a P-channel IGFET $Q_{81}$ in place of the WE. When the output Ns of the decoder circuit 12 is turned to a low level and the chip enable signal CE is turned to the low level, IGFETs $Q_{85}$ and $Q_{86}$ are rendered conductive so that the selected word line $WL_1$ is started to rise up to the final level $V_{cc}$. Here, when the selected word line WL reaches a certain level, the word level detection circuits $WDT_1''''$ detects that level to start its operation. If the driving capacity of the IGFET $Q_{81}$ in the select word drive circuit $WDR_1''''$ is preset larger than those of IGFETs $Q_{85}$ and $Q_{86}$ in the word drive circuit $WD_1$, the selected word line $WL_1$ has its rising gradient steepened at a time $t_0$, as shown in Fig. 14, so that the arrival time at the final time is shortened in comparison with the case, in which the select word line drive circuit $WDR_1''''$ is not added. On the contrary, in case the afore-mentioned arrival time is made the same, the dimensions of the IGFETs $Q_{85}$ and $Q_{86}$ can be reduced together with the load capacity of the signal CE.

Although the foregoing description is directed to the memory circuit, it is needless to say that the gist of the present invention should not be restricted thereto but can be extended to a general application, in which the signal of a signal line is intended to be self-amplified.

## Claims

1. A memory device comprising a plurality of word lines ($WL_1$—$WL_k$), a plurality of memory cells ($MC_{11}$—$MC_{kn}$), word selection means (12), a plurality of first word drive means ($WD_1$—$WD_k$) each coupled to a first portion ($W_0$) of an associated one of said word lines (WL) for driving the associated one of said word lines to a selection level ($V_{cc}$) when selected, a plurality of second word drive means ($WDR_1$—$WDR_k$) each coupled to an associated one of said word lines at a second portion thereof different from said first portion for operatively driving the associated one of said word lines together with the associated first word drive means, characterized in that the memory device further comprises a plurality of detection means ($WDT_1$—$WDT_k$) each coupled to an associated one of said word lines at a portion ($W_e$) thereof different from said first portion for detecting an initiation of a change towards said selection level in the associated one of said word lines and each of said second word drive means ($WDR_1$—$WDR_k$) is controlled by an output signal (DRS) of the associated one of said detection means ($WDT_1$—$WDT_k$) a section between said first and second portions of selected ones of said word lines being driven towards the selection level by both of the associated first drive means and the associated second drive means.

2. The memory device according to claim 1, characterized in that said word lines (WL) are made of polycrystalline silicon.

3. The memory device according to claim 1, characterized in that said detection means includes an inverter circuit having an input terminal coupled to said word line (WL).

4. The memory device according to claim 3, characterized in that said second word drive means (WDR) includes a transfer gate responsive to an output of said inverter circuit for transferring said selection level (Vcc) to the second portion (We) of said word line (WL).

5. The memory device according to claim 1, characterized in that said detection means is coupled to said word line (WL) at a portion near said second portion (We).

6. The device according to claim 2, in which said first portion (Wo) is one end of the word line (WL) and said second portion (We) is the other end opposite to said one end of the word line (WL).

7. An integrated circuit comprising a plurality of circuit means, a common line connected to said plurality of circuit means, first drive means (WD) connected to a first portion of said common line, said drive means (WD) being responsive to at least one input signal thereto for operatively supplying said common line with a drive potential, and second drive means (WDR) connected to said common line to a second portion thereof different from said first portion for operatively supplying said common line with a potential of the same polarity as said drive potential together with said first drive means, characterized in that the integrated circuit further comprises detection means ($WDT_1$) connected to said common line (WL) at a portion thereof different from said first portion for detecting a change towards said drive potential in said common line and said second drive means ($WDR_1$) is controlled by an output signal (DRS) of said detection means, a section between said first portion and said second portion of said common line being operatively driven towards the drive potential by said first and second drive means.

8. The integrated circuit according to claim 7, characterized in that said common line is made of polycrystalline silicon.

## Revendications

1. Dispositif à mémoire comprenant une pluralité de lignes de mots ($WL_1$—$WL_k$), une pluralité de cellules de mémoire ($MC_{11}$—$MC_{kn}$), un moyen de sélection de mots (12), une pluralité de premiers moyens de commande de mots ($WD_1$—$WD_k$) couplés chacun à une première partie ($W_0$) d'une ligne associée parmi les lignes de mots (WL) pour commander cette ligne associée à un niveau de sélection ($V_{cc}$)

lorsqu'elle est sélectionnée, une pluralité de seconds moyens de commande de mots (WDR$_1$.—WDR$_k$) couplés chacun à une ligne associée parmi les lignes de mots à une seconde partie de celle-ci différant de la première partie pour commander fonctionellement la ligne de mots associée des lignes de mots en même temps que le premier moyen de commande de mots associé, caractérisé en ce qu'il comprend en outre une pluralité de moyens de détection (WDT$_1$.—WDT$_k$) couplés chacun à une ligne associée des lignes de mots à une partie (W$_e$) de celle-ci différant de la première partie dans le but de détecter l'amorce d'une variation vers le niveau de sélection dans la ligne associée des lignes de mots et chacun des seconds moyens de commande de mots (WDR$_1$, WDR$_k$) est commandé par un signal de sortie (DRS) du moyen associé des moyens de détection (WDT$_1$, WDT$_k$) une section entre la première et la seconde partie des lignes sélectionnées des lignes de mots étant commandée vers le niveau de sélection par le premier moyen de commande associé ainsi que par le second moyen de commande associé.

2. Dispositif à mémoire selon la revendication 1, caractérisé en ce que le les lignes de mots (WL) sont en silicium polycrystallin.

3. Dispositif à mémoire selon la revendication 1, caractérisé en ce que le moyen de détection comprend un circuit inverseur ayant une borne d'entrée couplé à la ligne de mots (WL).

4. Dispositif à mémoire selon la revendication 3, caractérise en ce que le second moyen de commande de mots (WDR) comprend une porte de transfert répondant à une sortie du circuit inverseur pour transférer le niveau de sélection (V$_{cc}$) à la seconde partie (We) de la ligne de mots (WL).

5. Dispositif à mémoire selon la revendication 1, caractérisé en ce que le moyen de détection est couplée à la ligne de mots (WL) à une partie proche de la seconde partie (We).

6. Dispositif selon la revendication 2, caractérisé en ce que la première partie (Wo) est une extrémité de la ligne de mots (WL) et la seconde partie (We) est l'autre extrémité opposée à l'extrémité de la ligne de mots (WL).

7. Circuit intégré comprenant une pluralité de moyens de circuit, une ligne commune connectée à la pluralité de moyen de circuit, un premier moyen de commande (WD) connecté à une première partie de la ligne commune, le moyen de commande (WD) répondant à au moins un signal d'entrée pour fournir fonctionnellement à la ligne commune un potentiel de commande, et un second moyen de commande (WDR) connecté à la ligne commune à une seconde partie de celle-ci différant de la première partie pour fournir fonctionellement à la ligne commune un potentiel de même polarité que le potentiel de commande en même temps qu'au premier moyen de commande, caractérisé en ce qu'il comprend en outre un moyen de détection (WDT$_1$) connecté à la ligne commune (WL) à une partie de celle-ci différant de la première partie pour détecter une variation vers ledit potentiel de commande dans la ligne commune, et le second moyen de commande (WDR$_1$) est commandé par un signal de sortie (DRS) du moyen de détection, une section entre la première partie et la seconde partie de la ligne commune étant commandée fonctionnellement vers le potentiel de commande par les premier et second moyens d'entraînement.

8. Circuit intégré selon la revendication 7, caractérisé en ce que la ligne commune est en silicium polycristallin.

**Patentansprüche**

1. Speichervorrichtung mit einer Vielzahl von Wortleitungen (WL$_1$.—WL$_k$), einer Vielzahl von Speicherzellen (MC$_{11}$.—MC$_{kn}$), einer Wortauswahlvorrichtung (12), einer Vielzahl von Worttreibervorrichtungen (WD$_1$.—WD$_k$), die jeweils mit einem Teil (W$_0$) einer zugehörigen Wortleitung (WL) verbunden sind, um die zugehörige Wortleitung (WL) bei Auswahl auf einen Auswahlpegel (V$_{cc}$) zu steuern, einer Vielzahl von zweiten Worttreibervorrichtungen (WDR$_1$.—WDR$_k$) die jeweils mit einem zweiten vom ersten verschiedenen Teil der zugehörigen Wortleitung verbunden sind, um im Bertrieb die zugehörige Wortleitung gemeinsam mit der ersten Worttreibervorrichtung zu treiben, dadurch gekennzeichnet, daß die Speichervorrichtung außerdem eine Vielzahl von Detektiermitteln (WDT$_1$.—WDT$_k$) aufweist, die jeweils mit einem vom ersten Teil verschiedenen Teil (W$_e$) einer zugehörigen Wortleitung verbunden sind, um den Beginn des Übergangs zum Auswahlpegel in der zugehörigen Wortleitung festzustellen, und jede der zweiten Worttreibervorrichtungen (WDR$_1$.—WDR$_k$) durch ein Ausgangssignal (DRS) des zugehörigen Detektiermittels (WDT$_1$.—WDT$_k$) gesteuert wird, wobei ein Bereich zwischen dem ersten und dem zweiten Teil der ausgewählten Wortleitung sowohl durch die erste, als auch durch die zweite zugehörige Worttreibervorrichtung auf den Auswahlpegel gesteuert wird.

2. Speichervorrichtung nach Anspruch 1, dadurch gekennzeichnet, daß die Wortleitungen (WL) aus polykristallinem Silicium bestehen.

3. Speichervorrichtung nach Anspruch 1, dadurch gekennzeichnet, daß die Detektiermittel einen Inverterschaltkreis enthalten, dessen Eingangsklemme mit der Wortleitung (WL) verbunden ist.

4. Speichervorrichtung nach Anspruch 3, dadurch gekennzeichnet, daß die zweite Treibervorrichtung (WDR) ein Übertragungsgate enthält, das in Abhängigkeit vom Ausgangssignal des Inverterschaltkreises den Auswahlpegel (V$_{cc}$) an den zweiten Teil (W$_e$) der Wortleitung (WL) überträgt.

5. Speichervorrichtung nach Anspruch 1, dadurch gekennzeichnet, daß die Detektiermittel mit der Wortleitung (WL) verbunden sind in einem Teil nahe dem zweiten Teil ($W_e$).

6. Speichervorrichtung nach Anspruch 2, dadurch gekennzeichnet, daß der erste Teil ($W_0$) ein Ende der Wortleitung (WL) ist und daß der zweite Teil ($W_e$) das gegenüberliegende andere Ende der Wortleitung ist.

7. Integrierter Schaltkreis mit einer Vielzahl von Schaltungsvorrichtungen, einer gemeinsamen damit verbundenen Wortleitung, einer ersten mit einem ersten Teil der gemeinsamen Wortleitung verbundenen Triebervorrichtung (WD), die in Abhängigkeit von mindestens einem zugeführten Eingangssignal im Betrieb die gemeinsame Leitung mit einem Treiberpotential vorsorgt, und einer zweiten mit einem zweiten vom ersten verschiedenen Teil der gemeinsamen Leitung verbundenen Triebervorrichtung (WDR), um im Betrieb gemeinsam mit der ersten Triebervorrichtung die gemein-

same Leitung mit einem Potential der gleichen Polarität wie das (erste) Treiberpotential zu versorgen, dadurch gekennzeichnet, daß der integrierte Schaltkreis ferner eine Detektiervorrichtung ($WDT_1$) aufweist, die mit der gemeinsamen Wortleitung (WL) an einem vom ersten verschiedenen Teil verbunden ist, um den Übergang zum Treiberpotential auf der gemeinsamen Leitung festzustellen, und die zweite Triebervorrichtung ($WDR_1$) durch ein Ausgangssignal (DRS) der Detektiervorrichtung gesteuert wird, wobei ein Bereich zwischen dem ersten und dem zweiten Teil der gemeinsamen Leitung im Betrieb durch die erste und die zweite Triebervorrichtung auf das Treiberpotential gesteuert wird.

8. Integrierter Schaltkreis nach Anspruch 7, dadurch gekennzeichnet, daß die gemeinsame Leitung aus polykristallinem Silicium hergestellt ist.

**0019241**

Fig. 1

_Fig. 2_

**Fig. 3**

**Fig. 4**

0019241

*Fig. 5*

4

WD₁

12    V_cc    Q₁₀    WL₁    WDR₁    WDT₁

CE    Q₁₁    V_cc

Q₁₃    Q₁₄

ND

NAG    Q₁₂    W₀    W_e    Q₁₅

*Fig. 6*

V [V]

ND

5

VW₀    V'_We    (V_We)

2,5

Vth

0    t₁  10    20    30    t [ns]

*Fig. 7*

**0019241**

Fig. 8

Fig. 9

Fig. 10

6

**Fig. 12**

_Fig. 11_

_Fig. 13_

_Fig. 14_